# EUROPEAN PATENT SPECIFICATION

(11) **EP 3 859 410 B1**
(45) Date of publication and mention of the grant of the patent: **24.08.2022**
(21) Application number: 21153635.4
(22) Date of filing: 27.01.2021
(51) Int. Cl.: G02B 5/08, G02B 26/10

(54) **OPTICAL MIRRORS MADE OF CARBON FIBER COMPOSITE MATERIAL**
OPTISCHE SPIEGEL AUS KOHLENSTOFFFASERVERBUNDMATERIAL
MIROIRS OPTIQUES CONSTITUÉS DE MATÉRIAU COMPOSITE DE FIBRE DE CARBONE

(30) Priority: 28.01.2020 US 202062966781 P
(43) Date of publication of application: 04.08.2021
(73) Proprietor: Thorlabs GmbH, 85232 Bergkirchen (DE)
(72) Inventor: Böhme, Tobias, 85221 Dachau (DE); Krause, Egbert, 85221 Dachau (DE); Baumhackl, Stefan Michael Friedrich, 85221 Dachau (DE)
(74) Representative: Grättinger Möhring von Poschinger Patentanwälte Partnerschaft mbB

(56) References cited:
- US-A1- 2006 092 535
- US-A1- 2011 317 235
- US-B1- 9 810 820
- BAGHSIAHI HADI ET AL: "Active and adaptive CFRP mirror using MFC piezoeletric actuator for thermal deformation and atmospheric aberration correction", ENHANCED AND SYNTHETIC VISION 2003 : [CONFERENCE ENHANCED AND SYNTHETIC VISION 2002] ; 21 APRIL 2003, ORLANDO, FLORIDA, USA; [PROCEEDINGS OF SPIE ISSN 0277-786X], SPIE, US, vol. 11203, 3 January 2020 (2020-01-03), pages 112030P-112030P, XP060126697, DOI: 10.1117/12.2541341 ISBN: 978-1-5106-3673-6

## Description

### CROSS REFERENCE TO RELATED APPLICATIONS

This application claims the benefit of U.S. Provisional Patent Application No. 62/966,781 filed on January 28, 2020.

### FIELD OF THE INVENTION

The present invention relates to materials for making fast steering optical mirrors for laser deflection, and more specifically to a composite material based on carbon fibers, into the manufacturing of fast steering optical mirrors.

### BACKGROUND

For fast moving mirrors, e.g., as used for galvanometer scanners (Galvos) or single pivot-point mirrors, fast steering mirrors (FSM), all users are looking for lightweight mirrors with a maximum stiffness. A typical value used for the specification of mirrors is E/ρ², with E: Young modulus and p: density.

### Table 1 shows the typical values for actually used materials:

**Table 1 - E/ρ² for different materials**

| **Material** | Mass density ρ [g/cm³] | Young's Modulus [Gpa] | **E/ρ²** |
|---|---|---|---|
| **CFRP** | 1.78 | 205 | **64.70** |
| **SiC** | 3.21 | 420 | **40.76** |
| **Fused Silica (SiO₂)** | 2.20 | 76,5 | **15.79** |
| **Beryllium** | 1.85 | 318 | **93.12** |
| **Silicon** | 2.34 | 147 | **26.94** |

As can be seen from Table 1, carbon fiber reinforced polymer (CFRP) shows clear benefits compared to SiC and Si02 and is not toxic as Beryllium.

Carbon fibers (CF) are fibers composed mostly of carbon atoms. Carbon fibers have several advantages including high stiffness, high tensile strength, low weight, high chemical resistance, high temperature tolerance and low thermal expansion. These properties have made carbon fiber very popular in aerospace, civil engineering, military, and motorsports, as well as other sports equipment. However, carbon fiber composite has not been incorporated into optical equipment, such as high-speed mirrors. There is little knowledge about suitable components (correct fibers and orientation, resins for composite and top coating) required for the composite material in the fast steering optical mirror, and the additional problem of outgassing at the coating for high reflectivity. Presently, in the optical community, carbon fiber composite is considered not suitable for fast steering mirrors.

Therefore, there is a long-felt need for suitable components in fast steering optical mirrors made of carbon fiber composite material and a method of introducing a composite material based on carbon fibers into the manufacturing of optical mirrors.

US 2011/0317235 A1 discloses a mirror with a first material and a pivoting system with a second material, wherein the first material may include carbon fiber. It does not disclose that the mirror is comprised of a plurality of carbon fiber layers laid up in a resin, and is completely silent on the direction of the carbon fiber layers.

### SUMMARY

The invention is set forth in the appended claims.

### BRIEF DESCRIPTION OF THE DRAWINGS

FIG. 1 shows the front side of an optical mirror according to an embodiment.
FIG. 2 shows a support structure at the back side of an optical mirror according to an embodiment.
FIG. 3 shows a scheme to lay up of the carbon fiber layers in a mirror blank according to an embodiment.

### DETAILED DESCRIPTION OF THE PREFERRED EMBODIMENTS

The description of illustrative embodiments according to principles of the present invention is intended to be read in connection with the accompanying drawings, which are to be considered part of the entire written description. In the description of embodiments of the invention disclosed herein, any reference to direction or orientation is merely intended for convenience of description and is not intended in any way to limit the scope of the present invention. Relative terms such as "lower," "upper," "horizontal," "vertical," "above," "below," "up," "down," "top" and "bottom" as well as derivative thereof (e.g., "horizontally," "downwardly," "upwardly," etc.) should be construed to refer to the orientation as then described or as shown in the drawing under discussion. These relative terms are for convenience of description only and do not require that the apparatus be constructed or operated in a particular orientation unless explicitly indicated as such. Terms such as "attached," "affixed," "connected," "coupled," "interconnected," and similar refer to a relationship wherein structures are secured or attached to one another either directly or indirectly through intervening structures, as well as both movable or rigid attachments or relationships, unless expressly described otherwise. Moreover, the features and benefits of the invention are illustrated by reference to the exemplified embodiments. Accordingly, the invention expressly should not be limited to such exemplary embodiments illustrating some possible non-limiting combination of features that may exist alone or in other combinations of features; the scope of the invention being defined by the claims appended hereto.

This disclosure describes the best mode or modes of practicing the invention as presently contemplated. This description is not intended to be understood in a limiting sense, but provides an example of the invention presented solely for illustrative purposes by reference to the accompanying drawings to advise one of ordinary skill in the art of the advantages and construction of the invention. In the various views of the drawings, like reference characters designate like or similar parts.

CFRPs are composite materials. In this case the composite consists of two parts: a matrix and a reinforcement. In CFRP the reinforcement is carbon fiber, which provides the strength. The matrix is usually a polymer resin, such as epoxy, to bind the reinforcements together. Because CFRP consists of two distinct elements, the material properties depend on these two elements.

Reinforcement gives CFRP its strength and rigidity; measured by stress and elastic modulus respectively. Unlike isotropic materials like steel and aluminum, CFRP has directional strength properties. The properties of CFRP depend on the layouts of the carbon fiber and the proportion of the carbon fibers relative to the polymer.

In optical application, there are several components required for the composite material. And the composition of the best fibers, the orientation of the fibers and especially the resin, are selected so as to fulfill all requirements of the post processing (especially for the optical coating: heat resistance and outgassing) and the final application (maximum stiffness by using the correct fibers and the orientation of fibers for each layer in the composite structure).

The required stiffness is achieved by an orientation of the fibers in appropriate directions, depending on the design of each mirror.

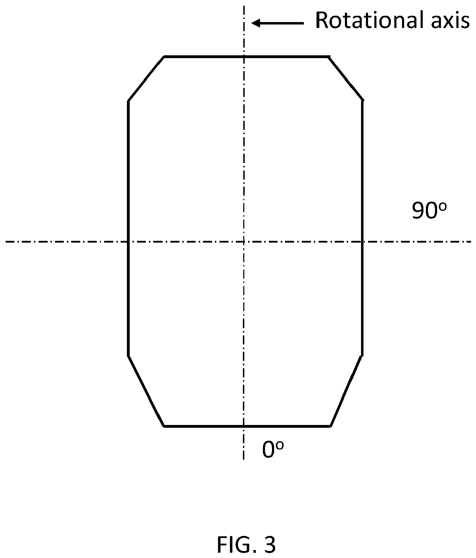

The standard thickness for fibers is about 0.2 mm to 0.25 mm. The fiber component may be a gauze made by such fibers, or single fibers. In one embodiment, the composite is a mixture of both. In one embodiment, the single fibers are quite fine with a thickness of 100-120 µm. By using the finer fibers, more layers may be built up for a plate of fixed thickness. A typical example for a flat mirror can lay up according to FIG. 3 in one embodiment. The rotational axis of the mirror and the orientation reference angles are also shown. Table 2 is an example of laying up the carbon fiber layers according to an embodiment.

**Table 2. Carbon Fiber Lay-Up Scheme**

| | **Material** | **Orientation (degrees)** |
|---|---|---|
| | UD | 90 |
| | Mesh | ±45 |
| | UD | 90 |
| | UD | 90 |
| | Mesh | ±45 |
| | UD | 90 |
| | UD | 90 |
| Symmetrical Axis | Mesh | 0/90 |
| | UD | 90 |
| | UD | 90 |
| | Mesh | ±45 |
| | UD | 90 |
| | UD | 90 |
| | Mesh | ±45 |
| | UD | 90 |

Here, UD (unidirectional) refers to a layer with fibers arranged in only one direction. Mesh correspond to bi-directional fiber layers. Fibers in two directions are weaved together to form a mesh, gauze, or twill. A specific lay-up scheme may be selected to provide more rigidity in certain desired directions that is suitable for a specific optical mirror design. In one embodiment, all fiber layers form a symmetrical stack with respect to its center (symmetrical axis).

For the coating process it is very important to find a suitable resin, which is heat resistant (more than 160°C) and does not outgas in vacuum. An additional aging process can improve these properties. In one example embodiment, the resin used is ER405.

In one embodiment, an additional layer of pure resin is added to help to improve the results of the polishing process and can be also used to compensate distortion after manufacturing of the composite material. Also, it is very important to find a suitable resin, which is heat resistant (more than 160°C) and does not outgas in vacuum. Typical materials used in some example embodiments include: RenLam ^{®} LY5210 and Aradur ^{®} 2954.

This additional layer (Top Coat) can be added either at one side or from both sides to compensate shrinkage and distortion. Typical thickness is between 0.1 mm and 1.0 mm. In one embodiment, the final optical coating can be a Silver-coating, an Aluminum-coating, a dielectric HR coating or any other coating, which is common for optical mirrors. Note that the carbon fiber material is sensitive to humidity. At the edges of the plate, the open fiber ends will absorb moisture, which will result in distortion. To avoid or reduce this effect, in one embodiment, a resin coating is applied to the cutting edges of the plate that have the open fiber ends. The resin is heat resistant and shows no outgassing at the coating process, similar to or the same as the resin, which is used in the top coating discussed above.

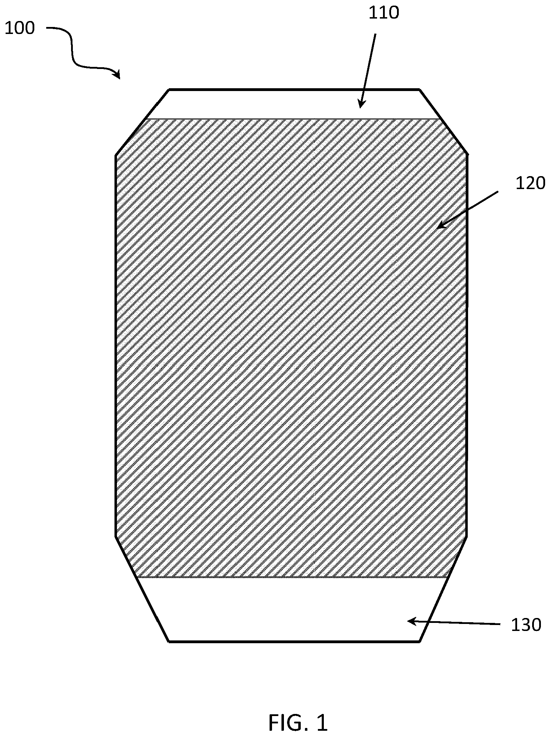

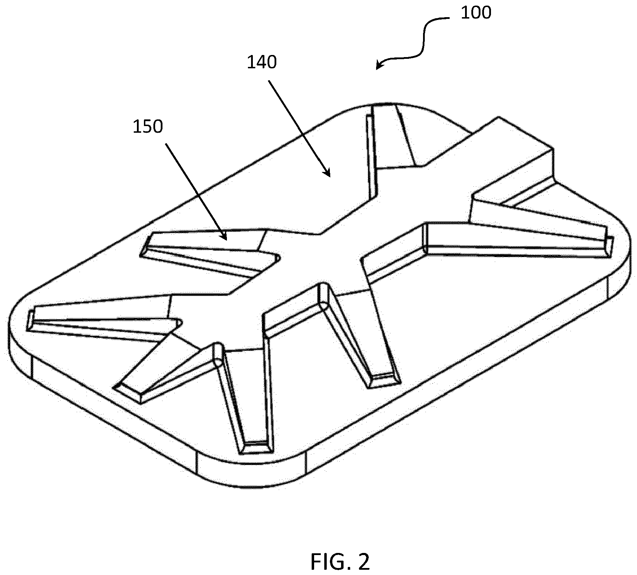

In one embodiment shown in FIG. 1, the fast steering optical mirror has a plate 100 containing multiple carbon fiber layers laid up in a resin. At least a portion 120 of the front face 110 of the plate 100 is polished and coated. The plate 100 includes a section 130 for mounting to a driving motor or an electromagnetic drive. As shown in FIG. 1, the design of the mirror is mostly plan parallel, but it can also have chamfers or bevels, as used for a reduction of thickness in the area, where the mirror will be fixed, in areas with less dynamic stress, or wherever a mass reduction is required. As there are very high accelerations for these mirrors, the deformations and oscillation will be reduced by the reduction of mass. For increasing the stiffness, support structures can be used in one embodiment. The support structures 150 on the back side 140 of the mirror plate can easily be realized (e.g. inspired by leafs of trees or from the aircraft industry), either by modelling the composite material or by machining, as shown in FIG. 2.

As the material is good to be milled, in one embodiment, the complete or a partial clamping unit can also be included in the design of the CF mirror. Note that typical mirror sizes start at an aperture of 6 mm can go easily up to 100 mm. However, designs according to embodiments of the present disclosure, there are no limitations by the material.

The optical mirrors made of carbon fiber composite material according to various embodiments of the present invention satisfy the long-felt need for suitable components in fast steering optical mirrors. The use of a composite material based on carbon fibers for making fast steering optical mirrors that meet the lightweight and stiffness requirements is an unexpected result, because carbon fiber composite is considered not suitable for fast steering mirrors by the optical community presently.

## Claims

1. A fast steering optical mirror for laser beam deflection, moved by at least one rotational axis, comprising:
a plate (100) comprising a plurality of carbon fiber layers laid up in a resin,
wherein the plate comprises a front face (110), at least a portion (120) of the front face being polished and coated for laser light reflection; and
wherein a surface normal of the front face is aligned orthogonal to the at least one rotational axis;
wherein the plurality of carbon fiber layers comprise one or more unidirectional carbon fiber layers and one or more bidirectional carbon fiber layers;
wherein fibers in the one or more unidirectional carbon fiber layers are aligned parallel to a rotational axis of the mirror; and
wherein fibers in the one or more bidirectional carbon fiber layers are aligned inclined to the rotational axis of the mirror.

2. The fast steering optical mirror of claim 1,
wherein the mirror has one rotational axis,
wherein the plate comprises a section (130) for mounting to a driving motor;
wherein the plate is aligned so that its centroid coincides with the one rotational axis and
wherein the surface normal of the front face is aligned orthogonal to the one rotational axis.

3. The fast steering optical mirror of claim 1,
wherein the mirror has two rotational axes,
wherein the plate comprises a section for mounting to an electromagnetic drive; and
wherein the surface normal of the front face is aligned orthogonal to one of the two rotational axes.

4. The fast steering optical mirror of one of claims 1 - 3, wherein the plate further comprises a layer of resin coated on the front face (110) and/or a back face (140) of the plate, wherein the layer of resin is temperature resistant and free of outgassing for additional processes, necessary to add the optical coatings for achieving maximum reflectivity.

5. The fast steering optical mirror of one of claims 1 - 3, wherein a back face (140) of the plate comprises a support structure (150).

6. The fast steering optical mirror of one of claims 1 - 3, wherein the plate further comprises a complete or partial clamping unit.

7. The fast steering optical mirror of one of claims 1 - 3, wherein at least one edge of the plate is chamfered or beveled.

8. The fast steering optical mirror of claim 1, wherein the fibers in the one or more bidirectional carbon fiber layers are aligned at about ±45° inclined to the rotational axis of the mirror.

9. The fast steering optical mirror of claim 1, wherein all the fiber layers form a symmetrical stack with respect to a center of the mirror.

10. The fast steering optical mirror of claim 3, wherein the two rotational axes are orthogonal to each other.

11. A method of manufacturing a fast steering optical mirror for laser beam deflection comprising:
forming a plate (100) having a front face (110) and a back face (140) by laying up a plurality of carbon fiber layers in a resin;
aligning the plate so that a surface normal of the plate is orthogonal to at least one rotational axis of the mirror; and
polishing and coating at least a portion (120) of the front face the front face for light reflection;
wherein the plurality of carbon fiber layers comprise one or more unidirectional carbon fiber layer and one or more bidirectional carbon fiber layer;
the method further comprising:
aligning the one or more unidirectional carbon fiber layers such that fibers in the one or more unidirectional carbon fiber layer are parallel to a rotational axis of the mirror; and
aligning the one or more bidirectional carbon fiber layers such that fibers in the one or more bi-directional carbon fiber layer are inclined to the rotational axis of the mirror.

12. The method of claim 11, further comprising coating a layer of resin on the front face and/or the back face of the plate, wherein the layer of resin is temperature resistant and free of outgassing for additional processes, necessary to add the optical coatings for achieving maximum reflectivity.

13. The method of claim 11, further comprising arranging all the fiber layers to form a symmetrical stack with respect to a center of the mirror.

## Patentansprüche

1. Schnell schwenkender optischer Spiegel für Laserstrahlablenkung, der von mindestens einer Drehachse bewegt wird und Folgendes aufweist:
eine Platte (100), die eine Mehrzahl an Kohlenstofffaserschichten, die in einem Harz aufgeschichtet sind, aufweist,
wobei die Platte eine Vorderfläche (110) aufweist, wobei mindestens ein Abschnitt (120) der Vorderfläche für Laserstrahlablenkung poliert und beschichtet ist; und
wobei die Oberflächennormale der Vorderfläche orthogonal zu der mindestens einen Drehachse ausgerichtet ist;
wobei die Mehrzahl an Kohlenstofffaserschichten eine oder mehrere unidirektionale Kohlenstofffaserschichten und eine oder mehrere bidirektionale Kohlenstofffaserschichten aufweist;
wobei Fasern in der einen oder den mehreren unidirektionalen Kohlenstofffaserschichten parallel zu einer Drehachse des Spiegels ausgerichtet sind; und
wobei Fasern in der einen oder den mehreren bidirektionalen Kohlenstofffaserschichten schräg zu der Drehachse des Spiegels ausgerichtet sind.

2. Schnell schwenkender optischer Spiegel nach Anspruch 1, wobei der Spiegel eine Drehachse aufweist,
wobei die Platte einen Bereich (130) zum Anbringen eines Antriebsmotors aufweist;
wobei die Platte derart ausgerichtet ist, dass ihr Schwerpunkt mit der einen Drehachse koinzidiert, und wobei die Oberflächennormale der Vorderfläche orthogonal zu der einen Drehachse ausgerichtet ist.

3. Schnell schwenkender optischer Spiegel nach Anspruch 1, wobei der Spiegel zwei Drehachsen aufweist,
wobei die Platte einen Bereich zum Anbringen an einem elektromagnetischen Antrieb aufweist; und
wobei die Oberflächennormale der Vorderfläche orthogonal zu einer der beiden Drehsachsen ausgerichtet ist.

4. Schnell schwenkender optischer Spiegel nach einem der Ansprüche 1 bis 3, wobei die Platte ferner eine Harzschicht aufweist, die auf der Vorderfläche (110) und/oder der Rückfläche (140) der Platte aufgetragen ist, wobei die Harzschicht temperaturbeständig und frei von Ausgasung für zusätzliche Vorgänge ist, die nötig sind, um die optischen Beschichtungen zur Erzielung maximaler Reflektivität hinzuzufügen.

5. Schnell schwenkender optischer Spiegel nach einem der Ansprüche 1 bis 3, wobei eine Rückfläche (140) der Platte eine Trägerstruktur (150) aufweist.

6. Schnell schwenkender optischer Spiegel nach einem der Ansprüche 1 bis 3, wobei die Platte ferner eine komplette oder teilweise Klemmeinheit aufweist.

7. Schnell schwenkender optischer Spiegel nach einem der Ansprüche 1 bis 3, wobei mindestens eine Kante der Platte abgeschrägt oder stumpfwinkelig ist.

8. Schnell schwenkender optischer Spiegel nach Anspruch 1, wobei Fasern in der einen oder den mehreren bidirektionalen Kohlenstofffaserschichten in einem Winkel von ±45° zu der Drehachse des Spiegels ausgerichtet sind.

9. Schnell schwenkender optischer Spiegel nach Anspruch 1, wobei alle Faserschichten einen symmetrischen Stapel bezüglich einer Mitte des Spiegels bilden.

10. Schnell schwenkender optischer Spiegel nach Anspruch 3, wobei die beiden Drehachsen orthogonal zueinander sind.

11. Verfahren zum Herstellen eines schnell schwenkenden optischen Spiegels für Laserstrahlablenkung, das Folgendes aufweist:
Bilden einer Platte (100), die eine Vorderfläche (110) und eine Rückfläche (140) aufweist, durch Stapeln einer Mehrzahl an Kohlenstofffaserschichten in einem Harz;
Ausrichten der Platte, derart dass eine Oberflächennormale der Platte orthogonal zu mindestens einer Drehachse des Spiegels ist; und
Polieren und Beschichten mindestens eines Abschnitts (120) der Vorderfläche der Vorderfläche für Lichtreflexion;
wobei die Mehrzahl an Kohlenstofffaserschichten eine oder mehrere unidirektionale Kohlenstofffaserschichten und eine oder mehrere bidirektionale Kohlenstofffaserschichten aufweist;
wobei das Verfahren Folgendes aufweist:
Ausrichten der einen oder mehreren unidirektionalen Kohlenstofffaserschichten, derart dass Fasern in der einen oder den mehreren unidirektionalen Kohlenstofffaserschichten parallel zu einer Drehachse des Spiegels sind; und
Ausrichten der einen oder mehreren bidirektionalen Kohlenstofffaserschichten, derart dass Fasern in der einen oder mehreren unidirektionalen Kohlenstofffaserschichten geneigt zu einer Drehachse des Spiegels sind.

12. Verfahren nach Anspruch 11, das ferner Auftragen einer Harzschicht auf der Vorderfläche und/oder der Rückfläche der Platte aufweist, wobei die Harzschicht temperaturbeständig und frei von Ausgasungen für zusätzliche Vorgänge ist, die nötig sind, um die optischen Beschichtungen zur Erzielung maximaler Reflektivität hinzuzufügen.

13. Verfahren nach Anspruch 11, das ferner Anordnen aller Faserschichten zum Bilden eines symmetrischen Stapels bezüglich einer Mitte des Spiegels aufweist.

## Revendications

1. Miroir optique à orientation rapide, pour la déflexion d'un faisceau laser, déplacé par au moins un axe de rotation, comprenant :
une plaque (100) comprenant une pluralité de couches de fibres de carbone mises en place dans une résine, dans lequel la plaque comprend une face avant (110), au moins une partie (120) de la face avant étant polie et revêtue pour la réflexion d'une lumière laser ; et
dans lequel une normale à la surface de la face avant est alignée orthogonalement à l'au moins un axe de rotation ;
dans lequel la pluralité des couches de fibres de carbone comprend une ou plusieurs couches de fibres de carbone unidirectionnelles et une ou plusieurs couches de fibres de carbone bidirectionnelles ;
dans lequel des fibres dans cette ou ces couches de fibres de carbone unidirectionnelles sont alignées parallèlement à un axe de rotation du miroir ; et
dans lequel des fibres dans cette ou ces couches de fibres de carbone bidirectionnelles sont alignées de manière inclinée par rapport à l'axe de rotation du miroir.

2. Miroir optique à orientation rapide selon la revendication 1,
dans lequel le miroir a un axe de rotation,
dans lequel la plaque comprend une section (130) pour le montage d'un moteur d'entraînement ;
dans lequel la plaque est alignée de sorte que son centroïde coïncide avec l'axe de rotation, et
dans lequel la normale à la surface de la face avant est alignée orthogonalement à l'axe de rotation.

3. Miroir optique à orientation rapide selon la revendication 1,
dans lequel le miroir a deux axes de rotation,
dans lequel la plaque comprend une section pour le montage sur une commande électromagnétique ; et
dans lequel la normale à la surface de la face avant est alignée orthogonalement à l'un des deux axes de rotation.

4. Miroir optique à orientation rapide selon l'une des revendications 1-3, dans lequel la plaque comprend en outre une couche de résine qui revêt la face avant (110) et/ou la face arrière (140) de la plaque, dans lequel la couche de résine est résistante aux températures et exempte de dégazage pour des traitement supplémentaires nécessaires pour ajouter les revêtements optiques pour obtenir une réflectivité maximale.

5. Miroir optique à orientation rapide selon l'une des revendications 1-3, dans lequel une face arrière (140) de la plaque comprend une structure de support (150).

6. Miroir optique à orientation rapide selon l'une des revendications 1-3, dans lequel la plaque comprend en outre une unité de serrage complète ou partielle.

7. Miroir optique à orientation rapide selon l'une des revendications 1-3, dans lequel au moins un bord de la plaque est chanfreiné ou biseauté.

8. Miroir optique à orientation rapide selon la revendication 1, dans lequel les fibres dans cette ou ces couches de fibres de carbone bidirectionnelles sont alignées de manière inclinée de près de ±45° par rapport à l'axe de rotation du miroir.

9. Miroir optique à orientation rapide selon la revendication 1, dans lequel toutes les couches de fibres forment une pile symétrique par rapport à un centre du miroir.

10. Miroir optique à orientation rapide selon la revendication 3, dans lequel les deux axes de rotation sont orthogonaux entre eux.

11. Procédé de fabrication d'un miroir optique à orientation rapide pour la déflexion d'un faisceau laser, comprenant :
la formation d'une plaque (100) ayant une face avant (110) et une face arrière (140) par mise en place d'une pluralité de couches de fibres de carbone dans une résine ;
l'alignement de la plaque de sorte qu'une normale à la surface de la plaque est orthogonale à au moins un axe de rotation du miroir ; et
le polissage et le revêtement d'au moins une partie (120) de la face avant pour la réflexion de la lumière ;
dans lequel la pluralité des couches de fibres de carbone comprend une ou plusieurs couches de fibres de carbone unidirectionnelles et une ou plusieurs couches de fibres de carbone bidirectionnelles ;
le procédé comprenant en outre :
l'alignement de cette ou ces couches de fibres de carbone unidirectionnelles de sorte que des fibres dans cette ou ces couches de fibres de carbone unidirectionnelles sont parallèles à un axe de rotation du miroir ; et
l'alignement de cette ou ces couches de fibres de carbone bidirectionnelles de sorte que des fibres dans cette ou ces couches de fibres de carbone bidirectionnelles sont inclinées par rapport à l'axe de rotation du miroir.

12. Procédé selon la revendication 11, comprenant en outre le revêtement, avec une couche de résine, de la face avant et/ou la face arrière de la plaque, dans lequel la couche de résine est résistante aux températures et exempte de dégazage pour des traitements supplémentaires nécessaires pour ajouter les revêtements optiques pour obtenir une réflectivité maximale.

13. Procédé selon la revendication 11, comprenant en outre l'agencement de toutes les couches de fibres pour former une pile symétrique par rapport à un centre du miroir.
